Europäisches Patentamt

European Patent Office

Office européen des brevets

(19)

(11) Veröffentlichungsnummer: **0 115 326**
A2

(12) # EUROPÄISCHE PATENTANMELDUNG

(21) Anmeldenummer: 84100722.2

(51) Int. Cl.³: **H 03 L 7/08**

(22) Anmeldetag: 24.01.84

(30) Priorität: 27.01.83 DE 3302700

(43) Veröffentlichungstag der Anmeldung:
08.08.84 Patentblatt 84/32

(84) Benannte Vertragsstaaten:
AT BE CH DE FR GB IT LI NL SE

(71) Anmelder: SIEMENS AKTIENGESELLSCHAFT
Berlin und München Wittelsbacherplatz 2
D-8000 München 2(DE)

(72) Erfinder: Gasser, Kurt
Lochhamer Strasse 22
D-8032 Gräfelfing(DE)

(54) Schaltungsanordnung zum Einstellen der Mittenfrequenz des Oszillators eines Phasenregelkreises.

(57) Schaltungsanordnung zum Einstellen der Mittenfrequenz des Oszillators eines Phasenregelkreises.
Bei einer Störung des Referenzsignals wird dem Phasendiskriminator anstelle des Referenzsignals ein zum vom Oszillator erzeugten Takt OT, der ebenfalls dem Phasendiskriminator zugeführt ist, inverses Signal $\overline{OT}$ zugeführt.

FIG 2

EP 0 115 326 A2

SIEMENS AKTIENGESELLSCHAFT

Berlin und München                    VPA  83 P 1028 E

Schaltungsanordnung zum Einstellen der Mittenfrequenz
eines Oszillators in einem Phasenregelkreis

Die Erfindung betrifft eine Schaltungsanordnung zum
Einstellen der Mittenfrequenz eines Oszillators in einem
Phasenregelkreis mit einem Phasendiskriminator, dessen
erstem Eingang ein vom Oszillator erzeugter Takt und
dessen zweitem Eingang ein Referenzsignal zugeführt ist,
mit einem dem Phasendiskriminator nachgeschaltetem Tiefpaß und mit einer Überwachungseinrichtung, die bei einer
Störung, insbesondere bei Ausfall oder bei einer unzulässigen Frequenzabweichung des Referenzsignals über
einen Umschalter   den Oszillator auf seine Mittenfrequenz umschaltet.

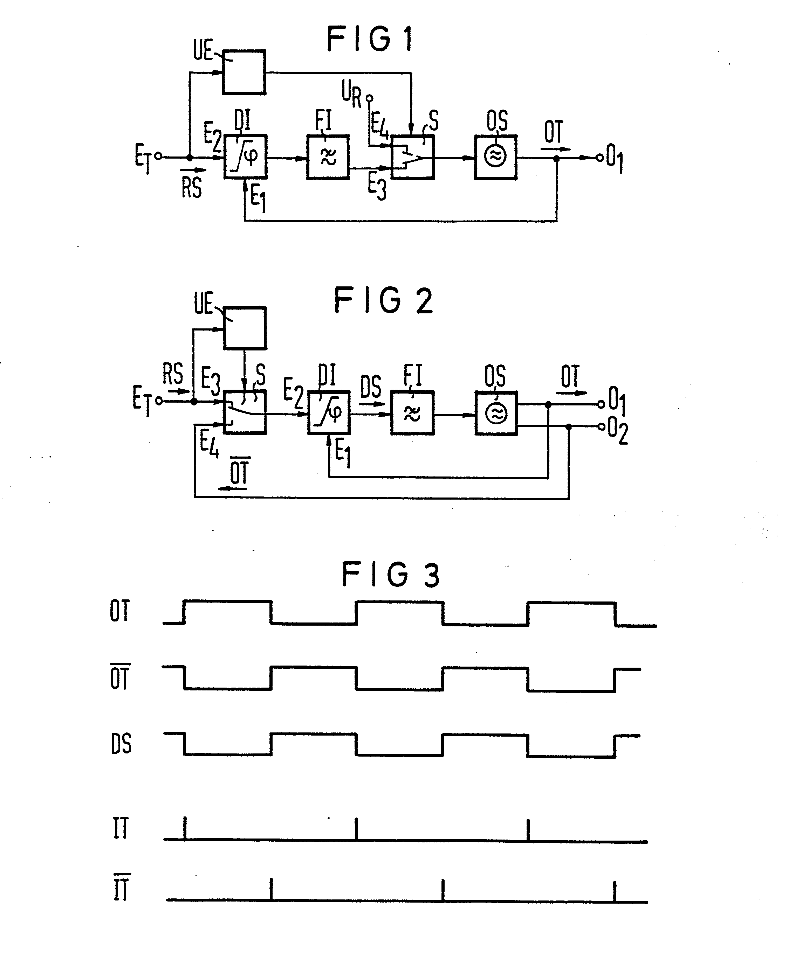

Bei den bisher bekannten Phasenregelkreisen (Phase-Locked-
Loop) wurde bei Ausfall des Referenzsignals die Steuerspannung des Oszillators durch Umschalten auf eine feste
Referenzspannung so festgelegt, daß der Oszillator seine
Mittenfrequenz abgab. Eine solche Einrichtung ist in
Fig. 1 dargestellt. Das plötzliche Umschalten auf die
Referenzspannung bewirkt eine plötzliche Frequenzänderung
des Oszillators. Bei vielen Anwendungsfällen der Phasenregelkreise muß die plötzliche Frequenzänderung jedoch vermieden werden. Dies ist beispielsweise dann der Fall, wenn
mehrere Phasenregelkreise in Serie geschaltet sind.

Aufgabe der Erfindung ist es, bei einem Phasenregelkreis
eine einfache Schaltungsanordnung zum Einstellen der
Mittenfrequenz des Oszillators anzugeben.

Diese Aufgabe wird dadurch gelöst, daß dem Umschalter
das Referenzsignal und ein zum vom Oszillator
erzeugten Takt inverses Signal zugeführt werden, daß der

0115326

Ausgang des Umschalters mit dem zweiten Eingang des Phasendiskriminators verbunden ist und daß bei gestörtem Referenzsignal das inverse Signal über den Umschalter an den zweiten Eingang des Phasendiskriminators geschaltet ist.

Bei dieser Schaltungsanordnung wird eine Referenzspannung zum Einstellen des Oszillators nicht benötigt. Die Umschaltung erfolgt vor dem Tiefpaß, so daß sich die Frequenz des Oszillators nur langsam ändert. Hat die Überwachungsschaltung nur eine kurze Zeitkonstante, so wird dem Phasendiskriminator der Phasenregelschleife ein nahezu konstantes Referenzsignal zugeführt, da das inverse Signal nahezu phasengleich mit dem Referenzsignal ist.

Es ist vorteilhaft, daß die Laufzeiten des vom Oszillator erzeugten Taktes und des hierzu inversen Signals , die dem Phasendiskriminator zugeführt werden, gleich sind.

Bei den meisten Phasendiskriminatoren genügt es, daß ihnen zum Phasenvergleich Impulse (Takte) zugeführt werden, die üblicherweise bei der Sollfrequenz um 180 Grad phasenverschoben sind. Die Impulse werden bei einer bestimmten Zählerstellung eines in den Phasenregelkreis eingefügten Frequenzteilers gewonnen.

Es ist zweckmäßig, daß anstelle des vom Oszillators erzeugten Taktes und des inversen Signals jeweils diesen Signalen entsprechende Impulse dem Phasendiskriminator zugeführt werden.

Ein Phasenregelkreis wird zweckmäßigerweise so ausgeführt, daß bei der Mittenfrequenz des Oszillators diesem auch eine mittlere Steuerspannung über den Tiefpaß zugeführt wird. In diesem Fall muß der Phasendiskriminator ein Diskriminatorsignal abgeben, dessen Puls-/Pausenverhältnis 1:1 ist.

Weitere vorteilhafte Ausbildungen der Erfindung sind in den übrigen Unteransprüchen angegeben.

Die Erfindung wird anhand eines Prinzipschaltbildes und eines Ausführungsbeispiels näher erläutert.

Es zeigen

Fig. 1    eine übliche Schaltungsanordnung zum Einstellen der Mittenfrequenz,

Fig. 2    ein Prinzipschaltbild der erfindungsgemäßen Schaltungsanordnung zum Einstellen der Mittenfrequenz,

Fig. 3    ein Impulsdiagramm,

Fig. 4    als Ausführungsbeispiel einen Pufferspeicher,

Fig. 5    ein Impulsdiagramm zu Fig. 4.

Ein Phasenregelkreis (Fig. 1) besteht aus einem Phasendiskriminator DI, einem diesem nachgeschalteten Tiefpaß FI und einem Oszillator OS, der an den Ausgang des Tiefpasses FI angeschaltet ist. Der Ausgang $O_1$ des Oszillators OS ist mit einem ersten Eingang $E_1$ des Phasendiskriminators DI verbunden, dem über seinen zweiten Eingang $E_2$ (dieser entspricht dem Referenzsignaleingang $E_T$ des Phasenregelkreises) ein Referenzsignal RS zugeführt wird. Zwischen dem Tiefpaß FI und dem Steuereingang des Oszillators OS ist ein Umschalter S eingefügt, der von einer Überwachung UE betätigt wird. Diese Überwachung prüft das Referenzsignal RS ständig. Die Überprüfung bezieht sich beispielsweise auf den Spannungspegel und die Frequenz des Referenzsignals. Bei einem gestörten Referenzsignal RS wird der Steuereingang des Oszillators OS über den Umschalter S an eine Referenzspannung $U_R$ angeschaltet, die den Oszillator auf seine Mittenfrequenz einstellt.

In Fig. 2 ist die erfindungsgemäße Schaltungsanordnung dargestellt. Sie enthält wie Fig. 1 einen Diskriminator DI, einen Tiefpaß FI und einen Oszillator OS, dessen Steuereingang jedoch direkt mit dem Ausgang des Tiefpasses FI verbunden ist. Der Umschalter S ist dem zweiten Eingang des Phasendiskriminators DI vorgeschaltet. Dem Umschalter S wird über den Referenzsignaleingang $E_T$ das Referenzsignal RS seinem ersten Eingang $E_3$ zugeführt. Seinem zweiten Eingang $E_4$ wird von einem invertierenden Ausgang $O_2$ des Oszillators ein zum erzeugten Takt OT inverses Signal $\overline{OT}$ zugeführt.

Bei einer Störung wird dem zweiten Eingang $E_2$ des Phasendiskriminators DI statt des Referenzsignals RS das inverse Signal $\overline{OT}$ zugeführt. Hierdurch ergibt sich ein Puls-/Pausenverhältnis des Diskriminatorsignals DS von 1:1.

Am Ausgang des Tiefpasses FI stellt sich langsam eine mittlere Steuerspannung ein, die den Oszillator auf seine Mittenfrequenz zieht.

Das in Fig. 3 dargestellte Impulsdiagramm soll die Funktion des Phasenregelkreises nochmals verdeutlichen. Im Idealfall sind bei einem eingerasteten Phasenregelkreis das Referenzsignal RS und der vom Oszillator erzeugte Takt OT üblicherweise um 180 Grad phasenverschoben. Das Referenzsignal entspricht dann dem zum erzeugten Takt inversen Signal $\overline{OT}$ . Fällt nun das Referenzsignal aus, wird auf den inversen Takt $\overline{OT}$ umgeschaltet. Dem Phasendiskriminator werden dann praktisch dieselben Eingangssignale zugeführt. Auch wenn der Oszillator im gerasteten Zustand bereits eine Steuerspannung benötigt, die nicht exakt dem Mittenwert entspricht, kommt es bei hochwertigen Phasenregelkreisen nur zu einer geringen Phasenverschiebung zwischen dem Referenzsignal und dem inversen Signal. Das Diskriminatorsignal DS weißt in Fig. 3 ein Puls-/Pausenverhältnis von 1:1 auf. Anstelle von Signalen mit 1:1 Verhältnis können den meisten Phasendiskriminatoren auch Impulse IT und $\overline{IT}$ zugeführt werden, die hier den positiven Flanken des erzeugten Taktes und des hierzu inversen Signals entsprechen.

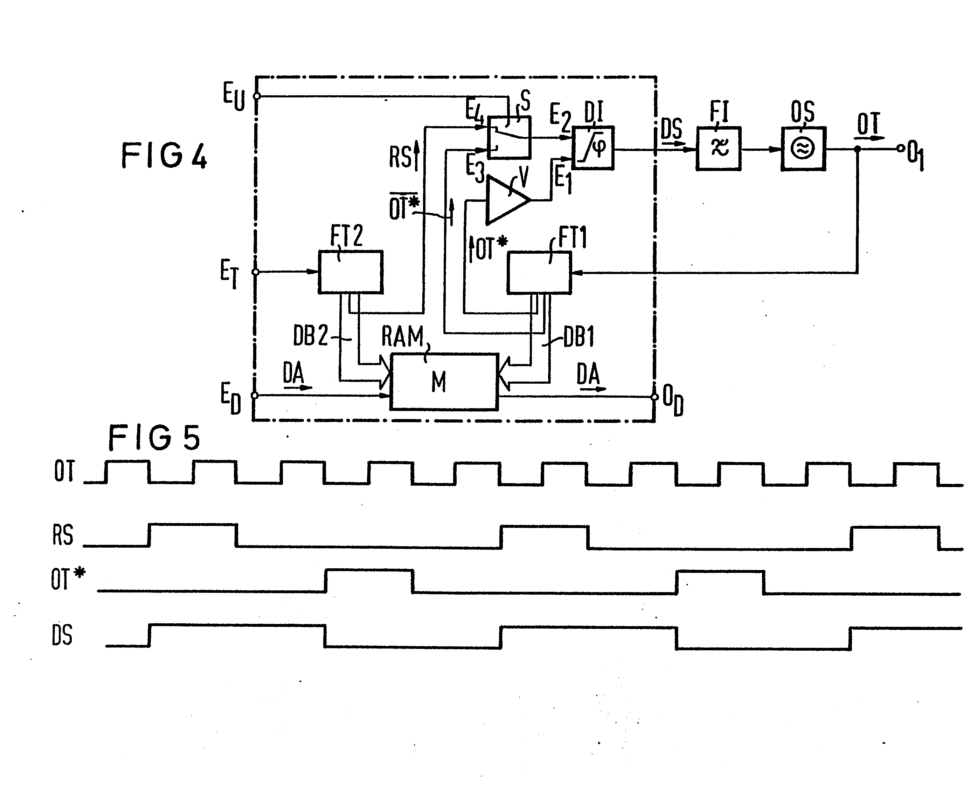

In Fig. 4 ist die Steuerung für einen Pufferspeicher
dargestellt, die einen Phasenregelkreis enthält. In dem
Phasenkreis selbst ist zwischen dem Ausgang $O_1$ des Oszillators OS und dem ersten Eingang $E_1$ des Phasendiskriminators DI ein Frequenzteiler FT2 und ein Verstärker V
eingeschaltet. Dem Eingang E1 des Phasendiskriminators
wird ein vom ersten Frequenzteiler FT1 abgegebener abgeleiteter Oszillatortakt OT*zugeführt.

Das Referenzsignal RS wird von einem zweiten Frequenzteiler FT2 abgegeben, an dessen Eingang $E_T$ ein Signal
mit einer entsprechend höheren Frequenz anliegt. Einem
Schreib-Lese-Speicher RAM werden die Daten DA über einen
Dateneingang $E_D$ zugeführt. An seinem Ausgang $O_D$ gibt er
die Daten wieder ab. Die Schreibadresse erhält der Schreib-
Lese-Speicher RAM über die Ausgänge DB2 des zweiten
Frequenzteilers FT2, die Leseadresse erhält er von den
Ausgängen DB1 des ersten Frequenzteilers FT1. An einem
Ausgang des zweiten Frequenzteilers FT2 wird das Referenzsignal RS abgegeben, vom entsprechenden Ausgang des
ersten Frequenzteilers FT1 wird das im Störungsfalle
verwendete abgeleitete inverse Signal dem Umschalter am
Eingang $E_4$ zugeführt. Die Überwachungseinrichtung wurde
nicht dargestellt, der Umschalter S erhält sein
Umschaltsignal über einen Umschalteingang $E_U$. Durch den
Verstärker V und über die Umschalteinrichtung S ergeben sich
gleiche Laufzeiten für die Eingangssignale des Phasendiskriminators DI, die beide von den Ausgängen des
ersten Frequenzteilers FT1 abgegeben werden.

Der Pufferspeicher hat die Funktion, die mit einem unregelmäßigen Takt eingelesenen Daten wieder kontinuierlich
abzugeben. Während der Auslesetakt, dies kann der vom
Oszillator erzeugte Takt OT oder ein durch Frequenzteilung
dieses Taktes gewonnener weiterer Takt sein, liest die
Daten aus dem Schreib-/Lese-Speicher aus. Der Eingabetakt
für Daten hat im Mittel dieselbe Frequenz wie der Auslesetakt, jedoch kommt der Einlesetakt unregelmäßig. Beispielsweise fehlt gelegentlich einer der am Eingang $E_T$ des zweiten Frequenzteilers FT2 anliegendenTakte. Durch den Phasenregelkreis ist dafür gesorgt, daß die Anzahl der Einlesetakte gleich der Anzahl der Auslesetakte ist, die Auslesetakte jedoch bei einer hohen Zeitkonstante des Phasenregelkreises jedoch praktisch kontinuierlich sind und hierdurch die Daten mit einer konstanten Geschwindigkeit abgegeben werden.

Als Phasendiskriminator DI kann im einfachsten Fall eine Setz-Rücksetz-Kippstufe verwendet werden. Ebenso können gebräuchliche Phasendiskrimatoren eingesetzt werden. Als Umschalter S wird ebenfalls ein handelsübliches elektronisches Bauelement eingesetzt.

Als Überwachungsschaltung ÜE kann im einfachsten Fall eine handelsübliche retriggerbare monostabile Kippstufe verwendet werden, der als Triggersignal das Referenzsignal RS zugeführt wird. Fällt das Referenzsignal aus, so geht das Ausgangssignal der monostabilen Kippstufe in die Ruhelage zurück und schaltet den Umschalter S um.

Für eine besonders schnelle Überwachungseinrichtung kann das Referenzsignal RS mit dem inversen Signal $\overline{OT}$ über eine DXCLUSIVE-OR-Verknpüfung bewertet werden. Sind die Phasenunterschiede zu groß, so ergibt die EXCLUSIVE-OR-Verknüpfung ein breites Ausgangssignal, dessen Dauer beispielsweise durch monostabile Kippstufen überwacht wird. Wird eine zulässige Breite überschritten, wird ebenfalls die Umschalteinrichtung betätigt.

Das Impulsdiagramm Fig. 5 zeigt die Impulse für die in Fig. 4 dargestellte Schaltungsanordnung. Es entspricht weitgehend dem Impulsdiagramm nach Fig. 3. Als Frequenzteiler werden Johnson-Zähler verwendet. Das Referenzsignal wird von dem zweiten Frequenzteiler TF2 abgegeben.

0115326

Der erste Frequenzteiler FT1 wird von dem Oszillatortakt OT angesteuert. Er gibt die von diesem Takt abgeleiteten Takte $OT^*$ und ein hierzu um 180° phasenverschobenes inverses Signal $\overline{OT}^*$ ab. Es entspricht im Idealfall - der Oszillator schwingt bei mittlerer Steuerspannung auf seiner Soll- bzw. Mittenfrequenz - dem Referenzsignal RS und wird im Störungsfall - wie bereits beschrieben - auch als Referenzsignal verwendet. Das Diskriminatorsignal DS weist im Störungsfall stets ein 1:1 Puls-/Pausenverhältnis auf, wodurch der Oszillator auf die Mittenfrequenz gestellt wird.

5 Ansprüche

5 Figuren

Patentansprüche

1. Schaltungsanordnung zum Einstellen der Mittenfrequenz eines Oszillators (OS) in einem Phasenregelkreis mit einem Phasendiskriminator (DI), dessen erstem Eingang (E₁) ein vom Oszillator (OS) erzeugter Takt (OT) und dessen zweitem Eingang (E₂) ein Referenzsignal (RS) zugeführt ist, mit einem dem Phasendiskriminator (DI) nachgeschalteten Tiefpaß (FI) und mit einer Überwachungseinrichtung (UE), die bei einer Störung, insbesondere bei Ausfall oder bei einer unzulässigen Frequenzabweichung des Referenzsignals (RS), über einen Umschalter (S) den Oszillator (OS) auf seine Mittenfrequenz umschaltet, d a d u r c h   g e k e n n z e i c h n e t , daß dem Umschalter (S) das Referenzsignal (RS) und ein zum vom Oszillator (OS) erzeugten Takt (OT) inverses Signal ($\overline{OT}$) zugeführt werden, daß der Ausgang des Umschalters (S) mit dem zweiten Eingang (E₂) des Phasendiskriminators (DI) verbunden ist und daß bei gestörtem Referenzsignal das inverse Signal ($\overline{OT}$) über den Umschalter (S) an den zweiten Eingang (E₂) des Phasendiskriminators (DI) geschaltet ist.

2. Schaltungsanordnung zum Einstellen der Mittenfrequenz eines Oszillators (OS) nach Anspruch 1, d a d u r c h   g e k e n n z e i c h n e t , daß die Laufzeiten des vom Oszillator (OS) erzeugten Taktes (OT) und des hierzu inversen Signals ($\overline{OT}$), die dem Phasendiskriminator (DI) zugeführt werden, gleich sind.

3. Schaltungsanordnung zum Einstellen der Mittenfrequenz eines Oszillators (OS) nach Anspruch 1 oder 2, d a d u r c h   g e k e n n z e i c h n e t , daß anstelle des vom Oszillator erzeugten Taktes (OT) und des inversen Signals ($\overline{OT}$) jeweils diesen Signalen entsprechende Impulse (IT, $\overline{IT}$) dem Phasendiskriminator (DI) zugeführt werden.

4. Schaltungsanordnung zum Einstellen der Mittenfrequenz eines Oszillators (OS) nach Anspruch 1 , d a d u r c h g e k e n n z e i c h n e t , daß als Überwachungseinrichtung (UE) eine retriggerbare monostabile Kippstufe vorgesehen ist.

5. Schaltungsanordnung zum Einstellen der Mittenfrequenz eines Oszillators (OS) nach Anspruch 1, d a d u r c h g e k e n n z e i c h n e t , daß die Überwachungseinrichtung (UE) ein EXCLUSIVE-OR-Gatter enthält, dessen erstem Eingang das Referenzsignal (RS) zugeführt ist und dessen zweitem Eingang das inverse Signal ($\overline{OT}$) zugeführt ist, und daß die Überwachungseinrichtung (UE) eine an den Ausgang des EXCLUSIVE-OR-Gatters angeschaltete Impulslängenmeßanordnung enthält.

1/2

FIG 1

FIG 2

FIG 3

FIG 4

FIG 5

OT

RS

OT*

DS